Europäisches Patentamt

European Patent Office

Office européen des brevets

(19)

(11)　**EP 1 653 619 A1**

(12)　## DEMANDE DE BREVET EUROPEEN

(43) Date de publication:
　　03.05.2006　Bulletin 2006/18

(51) Int Cl.:
　　*H03K 17/082* *(2006.01)*

(21) Numéro de dépôt: **05110042.8**

(22) Date de dépôt: **26.10.2005**

(84) Etats contractants désignés:
　　**AT BE BG CH CY CZ DE DK EE ES FI FR GB GR
　　HU IE IS IT LI LT LU LV MC NL PL PT RO SE SI
　　SK TR**
　　Etats d'extension désignés:
　　**AL BA HR MK YU**

(30) Priorité: **27.10.2004　FR 0452449**

(71) Demandeur: **ST MICROELECTRONICS S.A.
　　92120 Montrouge (FR)**

(72) Inventeur: **Fichera, Pietro
　　13080 Luynes (FR)**

(74) Mandataire: **de Beaumont, Michel et al
　　1bis, rue Champollion
　　38000 Grenoble (FR)**

Remarques:
　　Amended claims in accordance with Rule 86 (2) EPC.

(54)　**Protection d'un transistor de puissance**

(57)　L'invention concerne un procédé et un circuit de protection d'un transistor (M1, Mn) de commande en alimentation d'une charge (Q) au moins partiellement inductive, consistant à faire baisser la tension de démagnétisation de la charge inductive par rapport à une tension de démagnétisation fixée par un composant à retournement (DZ1, DZn) connecté entre une borne de conduction et la borne de commande du transistor.

Fig 2

EP 1 653 619 A1

**Description**

Domaine de l'invention

La présente invention concerne la protection de transistors véhiculant un courant d'alimentation d'une charge contre des sur-courants.

Un exemple d'application de la présente invention concerne la protection de transistors connectés en parallèle pour commander une charge au moins partiellement inductive, et plus particulièrement la réalisation de circuits individuels visant à protéger ces transistors lors de la démagnétisation de la charge inductive.

Exposé de l'art antérieur

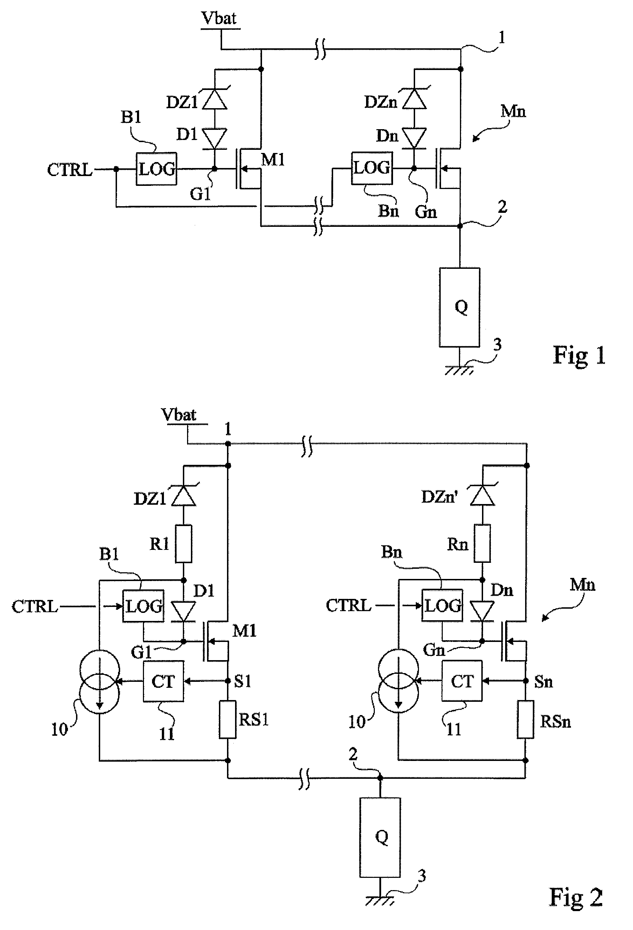

La figure 1 représente un exemple classique de montage associant plusieurs transistors MOS de puissance M (M1, ..., Mn) connectés en parallèle entre une borne 1 d'application d'une tension d'alimentation Vbat (par exemple, la tension d'une batterie) et une borne 2 de connexion à une charge Q à alimenter, l'autre extrémité de la charge étant par exemple connectée à la masse 3. Dans l'exemple de la figure 1, seuls deux transistors M1 et Mn ont été représentés. En pratique le nombre n de transistors M connectés en parallèle dépend de la puissance requise par la charge et du courant que chaque transistor peut supporter individuellement.

Tous les transistors M1 à Mn sont commandés à partir d'un même signal CTRL qu'ils reçoivent respectivement par l'intermédiaire de blocs B (B1 à Bn) logiques et d'adaptation de niveau (par exemple, des circuits de pompe de charge, de mise en forme, etc.) sur leurs bornes de commande (grille) respectives G (G1 à Gn). Les bornes de conduction respectives (drain et source) des transistors M sont directement connectées aux bornes 1 et 2.

Chaque transistor M est associé à un circuit de protection constitué d'une diode Zener DZ (DZ1, ..., DZn) en anti-série avec une diode D (D1, ..., Dn) entre la borne 1 et la grille G du transistor concerné.

Lorsque les transistors M1 à Mn sont commandés en fermeture par le signal CTRL, la charge Q se trouve alimentée par la tension Vbat. Les diodes DZ1 à DZn se trouvent polarisées en inverse. Les diodes DZ ne jouent aucun rôle pendant la phase de conduction dans la mesure où leurs tensions seuils sont supérieures à la tension d'alimentation, de sorte que la différence de tension entre le signal de commande CTRL et la tension Vbat ne les place pas en avalanche quand le signal CTRL est actif pour mettre en conduction les transistors M.

Lors d'une commande en ouverture des transistors M1 à Mn par un changement d'état du signal CTRL, se pose traditionnellement un problème de répartition du courant dans les transistors de puissance. Ce problème est particulièrement présent dans le cas d'une charge au moins partiellement inductive en raison du phénomène de démagnétisation. Cette démagnétisation entraîne que la tension de la borne 2 devient inférieure à la tension de la borne 3 (la masse), ce qui accroît considérablement la différence de potentiel entre les bornes 1 et 2. Pour évacuer le courant de démagnétisation, les transistors M1 et Mn doivent être rendus passants jusqu'à disparition de ce courant. C'est le rôle des diodes DZ1 à DZn qui fixent la tension de démagnétisation, c'est-à-dire la tension aux bornes de la charge inductive Q pendant l'évacuation dans l'alimentation du courant de démagnétisation. En fait, quand le potentiel de la borne 2 est abaissé par la démagnétisation à une valeur telle que la différence de potentiel entre les bornes 1 et 2 dépasse la tension seuil des diodes DZ, (en négligeant la tension grille-source Vgs des transistors M et la chute de tension VD dans chaque diode D polarisée en direct), ces diodes entrent en avalanche et imposent une tension positive entre grille et source des transistors M correspondants pour les rendre passants.

Quand la commande CTRL est inactive, la tension Vdemag de démagnétisation (tension aux bornes de la charge Q) peut s'écrire pour chaque transistor M :

$$Vdemag = Vbat - (VDZ + VD + Vgs),$$

où VDZ représente la tension seuil de la diode Zener DZ.

Les chutes de tension directes VD des diodes D sont toutes fixes (de l'ordre de 0,6 V) de même que les tensions Vgs des différents transistors MOS sont à peu près fixes ainsi que la tension de batterie Vbat. Par conséquent, dans la relation ci-dessus, on voit que le seul paramètre qui conditionne la tension de démagnétisation Vdemag de la charge est la tension seuil des diodes Zener DZ.

Les diodes Zener DZ1 à DZn sont donc toutes choisies pour avoir les mêmes valeurs nominales de façon à fixer la même tension de démagnétisation, pour tout le montage et répartir le courant dans toutes les branches.

Un inconvénient du circuit de la figure 1 est que les tolérances de fabrication et les dispersions technologiques font que les tensions seuils respectives des différentes diodes Zener DZ1 à DZn des circuits de protection des transistors M1 à Mn varient d'une branche à une autre. Ce problème est particulièrement présent dans le cas où chaque transistor de puissance M est intégré avec son circuit de protection et son bloc logique dans un circuit distinct des autres transistors qui sont ensuite associés en parallèle dans un montage tel que représenté en figure 1. La présence des blocs B empêche une liaison directe de toutes les grilles des transistors M ensemble, ce qui impose de prévoir un circuit de protection (diodes DZ et D) par branche.

En fait, la diode Zener DZ qui a la plus petite tension seuil conduit en premier et impose donc sur son transistor une tension Vgs positive de façon à le rendre passant pour évacuer le courant de démagnétisation. Comme les autres transistors M ne sont pas encore passants en raison du fait que les diodes Zener DZ de protection qui leur sont associées ont des seuils supérieurs, tout le courant traverse un seul transistor M et celui-ci se trouve donc endommagé car il n'est pas conçu pour supporter l'intégralité du courant.

Résumé de l'invention

La présente invention vise à éviter les inconvénients des circuits connus.

L'invention vise notamment à préserver l'équilibre entre les courants dans les différentes branches d'une association en parallèle de plusieurs transistors lors d'une démagnétisation sur charge inductive malgré d'éventuelles dispersions technologiques et tolérances de fabrication de diodes Zener de protection.

Pour atteindre tout ou partie de ces objets ainsi que d'autres, la présente invention prévoit un circuit de protection d'un transistor comportant, entre une première borne de conduction et une borne de commande, au moins un composant à retournement en anti-série avec un élément à conduction unidirectionnelle, caractérisé en ce qu'il comporte :

un élément résistif en série avec le composant à retournement ; et
une source de courant commandable entre une borne de l'élément à conduction unidirectionnelle opposée audit transistor et une deuxième borne de conduction du transistor.

Selon un mode de réalisation de la présente invention, ladite source de courant est commandée en fonction du courant dans ledit transistor.

Selon un mode de réalisation de la présente invention, la deuxième borne de conduction du transistor est destinée à être connectée à une charge au moins partiellement inductive, ladite source de courant faisant partie d'un circuit pour diminuer une tension de démagnétisation fixée par le composant à retournement.

Selon un mode de réalisation de la présente invention, la tension de démagnétisation est abaissée si le courant dans le transistor devient supérieur à un seuil.

Selon un mode de réalisation de la présente invention, le composant à retournement est une diode Zener.

Selon un mode de réalisation de la présente invention, ledit transistor est un transistor MOS.

L'invention prévoit également un circuit d'alimentation d'une charge par plusieurs transistors en parallèle connectés entre une première borne d'application d'une tension d'alimentation et une première borne de la charge, chaque transistor étant associé à un circuit de protection.

Selon un mode de réalisation de la présente invention, la charge est au moins partiellement inductive.

L'invention prévoit également un procédé de protection d'un transistor de commande en alimentation d'une charge au moins partiellement inductive, consistant à faire baisser la tension de démagnétisation de la charge par rapport à une tension de démagnétisation fixée par un composant à retournement connecté entre une borne de conduction et la borne de commande du transistor.

Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1 qui a été décrite précédemment est destinée à exposer l'état de la technique et le problème posé ;
la figure 2 représente, de façon schématique et sous forme de blocs, un mode de réalisation de circuits de protection de transistors de puissance selon la présente invention ; et
la figure 3 représente un mode de réalisation détaillé d'un transistor de puissance et de son circuit de protection selon l'invention.

Description détaillée

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, la constitution de la charge alimentée par plusieurs transistors de puissance en parallèle n'a pas été détaillée, l'invention étant compatible avec la charge commandée classiquement par des transistors en parallèle. De plus, la génération des signaux de commande de ces transistors de puissance n'a pas été détaillée et est compatible avec les systèmes classiques.

L'invention sera décrite par la suite en relation avec un exemple appliqué à des transistors MOS de puissance. On notera toutefois que celle-ci s'applique plus généralement quelle que soit la nature du transistor, par exemple, un transistor bipolaire.

La figure 2 représente, de façon schématique et partiellement sous forme de blocs, un mode de réalisation de circuits de protection de transistors MOS de puissance selon l'invention.

Comme précédemment, plusieurs (n) transistors MOS de puissance M1 à Mn sont connectés en parallèle entre une borne 1 d'application d'une tension d'alimentation Vbat (par exemple, la tension continue d'une batterie) et une borne 2 destinée à être connectée à une première borne de conduction d'une charge Q dont l'autre borne est connectée, par exemple, à la masse 3.

Selon le mode de réalisation représenté, l'électrode de commande (grille) de chaque transistor M est reliée à la borne 1 par une association en série d'une diode Zener DZ (DZ1 à DZn), d'une résistance R (R1 à Rn) et d'une diode D (D1 à Dn). La cathode de chaque diode DZ est reliée directement à la borne 1 tandis que la cathode de chaque diode D est reliée directement à la grille G (G1 à Gn) du transistor M auquel elle est associée. Chaque grille G reçoit un signal de commande CTRL par l'intermédiaire d'un bloc B (B1 à Bn) classique. En variante, la résistance R est intercalée entre la cathode de la diode DZ et la borne 1.

La résistance R est intercalée entre les anodes respectives de la diode DZ et de la diode D. Le rôle de la résistance R est d'augmenter fictivement la tension seuil de la diode Zener DZ afin d'abaisser la tension de source du transistor M et ainsi la tension de démagnétisation de la charge.

L'anode de la diode D est par ailleurs reliée à la borne 2 par une source de courant 10 commandable. La source 10 de chaque étage est commandée individuellement par un circuit 11 associé à l'étage concerné qui, dans l'exemple représenté, mesure le courant dans la branche principale (dans le transistor M concerné) au moyen d'une résistance RS (RS1 à RSn) reliant la source S (S1 à Sn) de chaque transistor à la borne 2.

Comme dans les réalisations classiques, les différentes diodes Zener utilisées sont prévues pour avoir une même tension seuil nominale mais peuvent avoir des tensions seuil réelles différentes d'une diode à l'autre en raison de dispersions technologiques et/ou des tolérances de fabrication.

Toutefois, ici, lorsque la première diode Zener (celle dont la tension seuil réelle est la plus faible) entre en avalanche, et rend passant le transistor M qui lui est associé, la circulation du courant dans ce transistor déclenche la source de courant 10 correspondante par l'intermédiaire du circuit 11. En pratique, le circuit 11 déclenche la source 10 de courant par rapport à un seuil choisi par exemple en fonction du courant maximum supportable par le transistor M. Plus le courant dans le transistor M (mesuré par la résistance RS) est élevé, plus le courant dans la source 10 est important.

La déviation du courant depuis la tension d'alimentation vers le point 2 grâce à la source 10 provoque fonctionnellement une diminution du niveau de la tension de démagnétisation, c'est-à-dire de la tension de la borne 2. Or, en diminuant le potentiel de la borne 2, on accélère le déclenchement des autres branches dont les tensions seuil des diodes Zener correspondantes sont plus élevées. On évite ainsi qu'une seule branche ait à supporter tout le courant de démagnétisation.

On voit que, dans une première phase, le courant dans le transistor M qui conduit le premier est maximal c'est-à-dire qu'il absorbe tout le courant de démagnétisation. Pendant cette phase, le courant dans la diode Zener DZ correspond au courant nominal pour laquelle cette diode est prévue d'après sa tension seuil. Toutefois cette première phase ne dure pas. Grâce à la diminution du potentiel du point 2 par l'action de la déviation du courant par la source 10, les autres branches entrent en conduction, ce qui place toutes les branches dans une deuxième phase où le courant dans la diode Zener correspond à la valeur nominale et où le courant est réparti dans les transistors M de façon équilibrée.

A titre de variante, on pourra mesurer la température des transistors M plutôt que les courants qui les traversent.

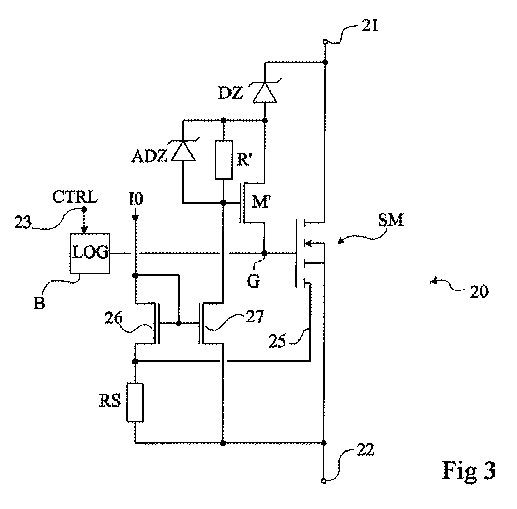

La figure 3 représente un exemple détaillé d'un circuit intégré 20 contenant un transistor de puissance (ici un transistor MOS SM) et un circuit de protection selon un mode de réalisation de l'invention. Par exemple, l'ensemble du circuit intégré 20 est un tripole dont une borne de commande 23 reliée en entrée du bloc B est destinée à recevoir le signal de commande CTRL et dont deux bornes de conduction 21 et 22 sont destinées à être respectivement connectées aux bornes 1 et 2 d'un montage associant en parallèle plusieurs circuits 20.

Dans l'exemple de la figure 3, la fonction de la diode D (figure 2) est assurée par un transistor auxiliaire M' (par exemple, MOS) dont une borne de conduction est connectée à l'anode de la diode DZ et dont l'autre borne de conduction est reliée à la grille G du transistor SM. La résistance R est dans cet exemple remplacée par une résistance R' entre l'anode de la diode DZ et la grille du transistor M' (donc toujours en série avec la diode DZ) et se trouve en parallèle avec une diode Zener auxiliaire ADZ qui a pour fonction de protéger le transistor M'. La tension seuil de la diode ADZ est inférieure à celle de la diode DZ. Par exemple, pour une diode DZ de l'ordre de 30 volts, une diode AD2 de l'ordre de quelques volts suffira.

Dans le mode de réalisation de la figure 3, pour éviter la présence de la résistance de détection en série avec le transistor M (figure 2), on utilise un transistor SM à mesure de courant ("sense FET") dont un borne auxiliaire 25 fournit une image du courant traversant ce transistor SM. Fonctionnellement, un tel transistor revient à connecter, entre la borne 21 et l'entrée (borne S) de mesure d'un bloc 11 (figure 2), un transistor additionnel (symbolisé par la borne auxiliaire 25) dont la grille est reliée à celle du transistor principal.

La borne 25 est reliée à une première borne d'une résistance de mesure RS dont l'autre borne est connectée à la borne principale 22. La première borne de la résistance RS est par ailleurs reliée à un premier transistor 26 (par exemple MOS) d'un miroir de courant dont l'autre borne de conduction reçoit un courant constant I0. Ce courant provient d'une source de courant externe classique qu'il n'est pas nécessaire de détailler. Le transistor 26 a sa borne de commande (sa grille) reliée à celle d'un autre transistor 27 (par exemple MOS) et à sa borne de conduction recevant le courant I0. Les deux bornes de conduction du transistor 27 sont respectivement reliées à la grille du transistor M' et à la borne 22. Le rôle du miroir de courant formé du transistor 26, 27 est de former une source de courant commandable adaptant le courant dévié par la résistance R' à partir du courant mesuré par la résistance RS.

Dans le cas où le montage comporte plus de deux branches en parallèle, une fois la première branche conductrice, il n'est pas obligatoire que les autres branches entrent simultanément en conduction. Leurs instants de conduction respectifs vont dépendre des seuils de leurs diodes Zener respectives. Toutefois, tant qu'un circuit de détection d'une des branches détecte dans le transistor principal de cette branche un courant supérieur à son seuil autorisé (fixé par son circuit 11, figure 2 ou par la constitution de son miroir de courant 26, 27, figure 3), il va chercher à faire baisser le potentiel de la borne 2 de façon à déclencher une autre branche.

Un avantage de la présente invention est qu'elle compense les éventuelles différences entre les tensions seuils des diodes Zener des circuits de protection des transistors connectés en parallèle.

Un autre avantage de l'invention est que les différents circuits en parallèle s'adaptent automatiquement aux constitutions des autres. A cet égard, on notera que chaque circuit de protection associé à un transistor de puissance est réalisé de façon indépendante aux autres branches. Par exemple, les tailles des transistors des différentes branches peuvent être différentes les unes des autres, les seuils respectifs de déclenchement des sources de courant de leurs circuits de protection étant alors également différents. Toutefois, les tensions seuil nominales des diodes Zener des circuits de protection sont, de préférence, choisies pour avoir toutes les mêmes valeurs.

Bien entendu, la présente invention est susceptible de diverses variantes et modifications qui apparaîtront à l'homme de l'art. En particulier, les dimensions à donner aux différents composants dépendent de l'application et sont à la portée de l'homme du métier à partir des indications fonctionnelles données ci-dessus. De plus, des sources de courant autres que celles illustrées par la figure 3 sont possibles, d'autres circuits pouvant réaliser la fonction de faire baisser le niveau de la tension de démagnétisation jusqu'à déclencher les diodes Zener des autres branches. En outre, on rappellera que bien que l'invention ait été décrite en relation avec une application à des transistors MOS, celle-ci s'applique plus généralement quel que soit le type de transistors (notamment bipolaire), les adaptations des commandes en tension pour les transformer en commande en courant (cas du bipolaire) étant à la portée de l'homme du métier.

**Revendications**

1. Circuit de protection d'un transistor (M1, Mn ; SM) comportant, entre une première borne de conduction (1 ; 21) et une borne de commande (G), au moins un composant à retournement (DZ1, DZn ; DZ) en anti-série avec un élément à conduction unidirectionnelle (D1, Dn ; M'), **caractérisé en ce qu'**il comporte :

   un élément résistif (R1, Rn ; R') en série avec le composant à retournement ; et
   une source de courant commandable (I0 ; 27) entre une borne de l'élément à conduction unidirectionnelle opposée audit transistor et une deuxième borne de conduction du transistor.

2. Circuit selon la revendication 1, dans lequel ladite source de courant (I0 ; 27) est commandée en fonction du courant dans ledit transistor (M1, Mn ; SM).

3. Circuit selon la revendication 1, dans lequel la deuxième borne de conduction (2 ; 21) du transistor (M1, Mn ; SM) est destinée à être connectée à une charge (Q) au moins partiellement inductive, ladite source de courant (I0 ; 27) faisant partie d'un circuit (I0, 11 ; 26, 27) pour diminuer une tension de démagnétisation fixée par le composant à retournement.

4. Circuit selon la revendication 1, dans lequel la tension de démagnétisation est abaissée si le courant dans le transistor (M1, Mn) devient supérieur à un seuil.

**5.** Circuit selon la revendication 1, dans lequel le composant à retournement est une diode Zener (DZ1, DZn ; DZ).

**6.** Circuit selon la revendication 1, dans lequel ledit premier transistor (M1, Mn ; SM) est un transistor MOS.

**7.** Circuit d'alimentation d'une charge (Q) par plusieurs transistors (M1, Mn) en parallèle connectés entre une première borne (1) d'application d'une tension (Vbat) d'alimentation et une première borne (2) de la charge, **caractérisé en ce que** chaque transistor est associé à un circuit de protection selon l'une quelconque des revendications 1 à 6.

**8.** Circuit selon la revendication 7 d'alimentation d'une charge (Q) au moins partiellement inductive.

**9.** Procédé de protection d'un transistor (M1, Mn ; SM) de commande en alimentation d'une charge (Q) au moins partiellement inductive, **caractérisé en ce qu'**il consiste à faire baisser la tension de démagnétisation de la charge par rapport à une tension de démagnétisation fixée par un composant à retournement (DZ1, DZn ; DZ) connecté entre une borne de conduction (1, 21) et la borne (G1, Gn ; G) de commande du transistor.


**Revendications modifiées conformément à la règle 86(2) CBE.**

**1.** Circuit de protection d'un transistor (M1, Mn ; SM) comportant, entre une première borne de conduction (1 ; 21) et une borne de commande (G), au moins une diode Zener (DZ1, DZn ; DZ) en anti-série avec un élément à conduction unidirectionnelle (D1, Dn ; M'), **caractérisé en ce qu'**il comporte :

un élément résistif (R1, Rn ; R') en série avec ladite diode Zener ; et
une source de courant commandable (10 ; 27) entre une borne de l'élément à conduction unidirectionnelle côté diode Zener et une deuxième borne de conduction du transistor.

**2.** Circuit selon la revendication 1, dans lequel ladite source de courant (10 ; 27) est commandée en fonction du courant dans ledit transistor (M1, Mn ; SM).

**3.** Circuit selon la revendication 1, dans lequel la deuxième borne de conduction (2 ; 21) du transistor (M1, Mn ; SM) est destinée à être connectée à une charge (Q) au moins partiellement inductive, ladite source de courant (10 ; 27) faisant partie d'un circuit (10, 11 ; 26, 27) pour diminuer une tension de démagnétisation fixée par le composant à retournement.

**4.** Circuit selon la revendication 1, dans lequel la tension de démagnétisation est abaissée si le courant dans le transistor (M1, Mn) devient supérieur à un seuil.

**5.** Circuit selon la revendication 1, dans lequel ledit premier transistor (M1, Mn ; SM) est un transistor MOS.

**6.** Circuit d'alimentation d'une charge (Q) par plusieurs transistors (M1, Mn) en parallèle connectés entre une première borne (1) d'application d'une tension (Vbat) d'alimentation et une première borne (2) de la charge, **caractérisé en ce que** chaque transistor est associé à un circuit de protection selon l'une quelconque des revendications 1 à 5.

**7.** Circuit selon la revendication 6 d'alimentation d'une charge (Q) au moins partiellement inductive.

**8.** Procédé de protection d'un transistor (M1, Mn ; SM) de commande en alimentation d'une charge (Q) au moins partiellement inductive, **caractérisé en ce qu'**il consiste à faire baisser la tension de démagnétisation de la charge par rapport à une tension de démagnétisation fixée par une diode Zener (DZ1, DZn ; DZ) connectée entre une borne de conduction (1, 21) et la borne (G1, Gn ; G) de commande du transistor.

Fig 1

Fig 2

Fig 3

**Office européen
des brevets**

**RAPPORT DE RECHERCHE EUROPEENNE**

Numéro de la demande

EP 05 11 0042

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 6 054 740 A (BARRET ET AL) 25 avril 2000 (2000-04-25) | 1 | H03K17/082 |
| A | * abrégé; figures 2-4,6 * * colonne 1, ligne 48 - ligne 54 * * colonne 2, ligne 48 - ligne 65 * ----- | 3,5,6,9 | |
| A | DE 198 41 227 C1 (SIEMENS AG) 23 mars 2000 (2000-03-23) * figure 1 * ----- | 1,5,6 | |
| A | DE 44 28 675 A1 (SIEMENS AG, 80333 MUENCHEN, DE) 15 février 1996 (1996-02-15) * figures 1,6-12 * ----- | 1,3,5,9 | |
| A | US 6 078 204 A (COOPER ET AL) 20 juin 2000 (2000-06-20) * abrégé; figures 1,4 * * colonne 1, ligne 27 - ligne 36 * * colonne 2, ligne 64 - colonne 3, ligne 17 * * colonne 3, ligne 31 - ligne 40 * ----- | 1,5,6 | |
| | | | DOMAINES TECHNIQUES RECHERCHES (IPC) |
| A | ANONYMOUS: "Parallel output drivers for inductive load" RESEARCH DISCLOSURE, KENNETH MASON PUBLICATIONS, HAMPSHIRE, GB, vol. 438, no. 22, octobre 2000 (2000-10), XP007126890 ISSN: 0374-4353 * le document en entier * ----- | 1,4-6 | H03K |
| A | "ANNOUNCEMENT" ELECTRONIQUE, CEP COMMUNICATION, PARIS, FR, no. 36, 1 mars 1994 (1994-03-01), pages 86-87, XP000440248 ISSN: 1157-1152 * colonne 1, ligne 1 - colonne 2, ligne 5 * ----- | 7,8 | |

Le présent rapport a été établi pour toutes les revendications

| Lieu de la recherche | Date d'achèvement de la recherche | Examinateur |
|---|---|---|
| Munich | 25 novembre 2005 | Mesic, M |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 05 11 0042

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

25-11-2005

| Document brevet cité au rapport de recherche | | Date de publication | Membre(s) de la famille de brevet(s) | | Date de publication |
|---|---|---|---|---|---|
| US 6054740 | A | 25-04-2000 | EP<br>FR<br>JP<br>JP | 0881682 A1<br>2764136 A1<br>2940547 B2<br>10335664 A | 02-12-1998<br>04-12-1998<br>25-08-1999<br>18-12-1998 |
| DE 19841227 | C1 | 23-03-2000 | FR | 2786890 A1 | 09-06-2000 |
| DE 4428675 | A1 | 15-02-1996 | AUCUN | | |
| US 6078204 | A | 20-06-2000 | AUCUN | | |

EPO FORM P0460

Pour tout renseignement concernant cette annexe : voir Journal Officiel de l'Office européen des brevets, No.12/82